# FASCICULE DE BREVET EUROPEEN

(11) **EP 2 591 138 B1**
(45) Date de publication et mention de la délivrance du brevet: **19.11.2014**
(21) Numéro de dépôt: 11743096.7
(22) Date de dépôt: 05.07.2011
(51) Int. Cl.: C23C 14/04, C23C 14/58, F01D 5/28, C23C 18/12, C23C 30/00

(54) **BARRIERE THERMIQUE POUR AUBE DE TURBINE, A STRUCTURE COLONNAIRE AVEC DES COLONNES ESPACEES**
WÄRMEBARRIERE FÜR TURBINENSCHAUFELN MIT SÄULENARTIGER STRUKTUR MIT DISTANZIERTEN SÄULEN
THERMAL BARRIER FOR TURBINE BLADES, HAVING A COLUMNAR STRUCTURE WITH SPACED-APART COLUMNS

(30) Priorité: 06.07.2010 FR 1055462
(43) Date de publication de la demande: 15.05.2013
(73) Titulaire: Snecma, 75015 Paris (FR)
(72) Inventeur: MENUEY, Justine, F-77550 Moissy-Cramayel Cedex (FR); HAMADI, Sarah, F-77550 Moissy-Cramayel (FR); HUGOT, Juliette, F-77550 Moissy-Cramayel (FR); MALIE, André, Hubert, Louis, F-77550 Moissy-Cramayel (FR); CRABOS, Fabrice, F-64510 Assat (FR)
(74) Mandataire: Gevers France
(86) Numéro de dépôt international: PCT/FR2011/051596
(87) Numéro de publication internationale: WO 2012/004525

(56) Documents cités:
- EP-A1- 1 645 655
- US-A1- 2002 106 457
- US-A1- 2005 266 163
- US-A1- 2009 017 260

## Description

Le domaine de la présente invention est celui des turbomachines et, plus particulièrement celui des pièces de ces turbomachines qui sont soumises à de fortes températures.

Une turbomachine, telle qu'utilisée pour la propulsion dans le domaine aéronautique comprend une entrée d'air atmosphérique qui communique avec un ou plusieurs compresseurs, dont généralement une soufflante, entraînés en rotation autour d'un même axe. Le flux primaire de cet air, après avoir été comprimé, alimente une chambre de combustion disposée annulairement autour de cet axe et est mélangé à un carburant pour fournir des gaz chauds, en aval, à une ou plusieurs turbines à travers lesquelles ceux-ci sont détendus, les rotors de turbine entraînant les rotors des compresseurs. Les moteurs fonctionnent à une température des gaz moteurs en entrée de turbine, que l'on cherche aussi élevée que possible car cette température conditionne les performances de la turbomachine. Dans ce but les matériaux des parties chaudes sont sélectionnés pour résister à ces conditions de fonctionnement et les parois des pièces balayées par les gaz chauds, telles que les distributeurs ou les ailettes mobiles de turbine, sont pourvues de moyens de refroidissement. Par ailleurs, en raison de leur constitution métallique en superalliage à base de nickel ou de cobalt de ces aubes, il est nécessaire aussi de les prémunir contre l'érosion et la corrosion qui sont engendrées par les constituants des gaz moteurs à ces températures.

Parmi les protections imaginées pour permettre à ces pièces de résister à ces conditions extrêmes figure le dépôt d'un revêtement, appelé barrière thermique, sur leur face externe. Une barrière thermique se compose généralement d'une couche céramique d'environ une centaine de microns, qui est déposée à la surface de la couche métallique. Une sous-couche en aluminium, de quelques dizaines de microns, placée entre la céramique et le substrat métallique, complète la barrière thermique en assurant la liaison entre ces deux composants ainsi que la protection du métal sous-jacent contre l'oxydation. Cette sous-couche en aluminium, qui est généralement déposée par un procédé d'aluminisation en phase vapeur (dit APVS pour la version du procédé mise en oeuvre par la demanderesse), se fixe au substrat par inter-diffusion métallique et forme une couche protectrice d'oxyde en surface. Un exemple de la mise en oeuvre de cette technique est décrit dans la demande de brevet FR 2928664 de la demanderesse.

Quant à la barrière thermique proprement dite, en céramique, elle peut être réalisée de plusieurs façons, selon l'utilisation qui en sera faite. On distingue grossièrement deux types de structures pour les barrières thermiques : des barrières colonnaires dont la structure est celle de colonnes juxtaposées les unes à côté des autres et qui s'étendent perpendiculairement à la surface du substrat, et des barrières lamellaires ou isotropes qui s'étendent en couches uniformes sur la surface du substrat.

Les premières sont généralement réalisées par un procédé dit EB PVD (pour Electron Beam Physical Vapor Déposition ou dépôt physique en phase vapeur par faisceau d'électrons) dans lequel une anode cible est bombardée, sous vide poussé, par un faisceau d'électrons émis par un filament de tungstène chargé. Le faisceau d'électrons fait passer les molécules de la cible en phase gazeuse. Ces molécules précipitent alors sous une forme solide, recouvrant la pièce à protéger d'une couche mince du matériau de l'anode. Ces barrières thermiques se caractérisent par une bonne tenue en cyclage thermique mais aussi par une conductivité thermique relativement élevée.

Les barrières isotropes sont généralement déposées par plasma, à l'aide d'un procédé de projection thermique du type APS (Atmospheric plasma spraying ou plasma d'arc soufflé) ou par un procédé dit sol-gel. Le procédé sol-gel permet par une simple polymérisation de précurseurs moléculaire en solution, d'obtenir, à une température proche de la température ambiante, des matériaux vitreux sans passer par une étape de fusion. Ces précurseurs existent pour un grand nombre de métaux et sont, pour la plupart, solubles dans des solvants usuels. Dans cette phase liquide désignée sous le nom de sol, les réactions chimiques contribuent à la formation d'un réseau inorganique tridimensionnel, connu sous le nom de gel, dans lequel le solvant demeure. L'obtention du matériau, à partir du gel, passe par une étape de séchage qui consiste à évacuer le solvant en dehors du réseau polymérique. L'intérêt d'une telle barrière est la porosité qu'elle présente.

Les barrières isotropes se caractérisent donc par une faible conductivité thermique, ce qui est le but recherché, mais elles présentent une résistance au cyclage thermique insuffisante. Les barrières obtenues par le procédé sol-gel ont, quant à elles, une tenue médiocre à l'érosion.

On connait enfin des barrières thermiques multifissurées obtenues par plasma à l'aide d'un procédé décrit dans plusieurs brevets de la demanderesse (EP1645654 et EP1471162), qui présentent un compromis acceptable entre la durée de vie et la tenue à l'érosion.

Toutes ces barrières ne sont toutefois pas suffisamment performantes et il est nécessaire d'améliorer encore leurs performances dans ces deux domaines.

US 2002/0106457 A divulgue le dépôt d'une couche céramique par EB PVD au travers d'une grille percée de trous.

La présente invention a pour but de remédier à ces inconvénients en proposant un procédé de réalisation d'une barrière thermique qui ne comportent pas certains des inconvénients de l'art antérieur et, notamment, qui présente une conductivité faible associée à une bonne durée de vie.

A cet effet, l'invention a pour objet un procédé de dépôt d'une couche céramique sur un substrat métallique pour la réalisation d'une barrière thermique, comportant une étape de dépôt de ladite céramique en structure colonnaire, caractérisé en ce que ledit dépôt s'effectue au travers d'une grille percée de trous, positionnée parallèlement à la surface du substrat de façon à réaliser au moins deux colonnes de céramique séparées l'une de l'autre par un espacement.

Les colonnes ainsi réalisées suffisent pour assurer la tenue mécanique de la barrière et sa résistance à l'érosion et laissent, par ailleurs, de l'espace entre elles pour remplir celui-ci avec un matériau le plus approprié. L'invention ouvre ainsi une grande flexibilité pour la constitution de la barrière thermique.

Avantageusement la largeur des trous est comprise entre 10 et 300 microns.

Préférentiellement l'espacement entre les trous est compris entre 10 et 100 microns.

Dans un mode particulier de réalisation le procédé comporte en outre une étape ultérieure de dépôt d'une couche isotrope de céramique dans lesdits espacements.

La structure isotrope du dépôt dans les espacements garantit une bonne étanchéité de la barrière contre l'invasion des gaz oxydants de la veine en direction du substrat.

Avantageusement le second dépôt s'effectue par une opération de trempé du substrat muni de ses colonnes dans une solution du type sol-gel.

On obtient ainsi une céramique à structure isotrope qui présente une grande porosité et donc une faible conductivité thermique.

De façon préférentielle le dépôt isotrope s'effectue par une succession d'opérations de trempé et de retrait dans ladite solution sol-gel et d'opérations de séchage effectuées entre deux opérations de trempé et de retrait, jusqu'à obtention d'une épaisseur sensiblement égale à la hauteur des colonnes.

Dans cette configuration les colonnes assurent à la fois une bonne résistance mécanique et une protection de la couche isotrope.

Avantageusement le procédé comporte en outre une étape finale de traitement thermique.

L'invention porte également sur une barrière thermique déposée sur un substrat métallique caractérisée en ce qu'elle comporte des colonnes en céramique s'étendant perpendiculairement à la surface dudit substrat et séparées les unes des autres par des espacements, lesdits espacements étant remplis par une couche de céramique isotrope.

Avantageusement les colonnes ont une largeur maximale comprise entre 10 et 300 microns.

De façon préférentielle les espacements ont une largeur comprise entre 10 et 100 microns.

Dans un mode particulier de réalisation la couche isotrope est réalisée en céramique poreuse.

L'invention porte enfin sur une aube de turbine pour turbomachine comportant une barrière thermique telle que décrite ci-dessus et sur une turbomachine comportant au moins une telle aube.

L'invention sera mieux comprise, et d'autres buts, détails, caractéristiques et avantages de celle-ci apparaîtront plus clairement au cours de la description explicative détaillée qui va suivre d'un mode de réalisation de l'invention donné à titre d'exemple purement illustratif et non limitatif, en référence aux dessins schématiques annexés.

Sur ces dessins :
- la figure 1 est une vue schématique de la constitution physique d'une barrière thermique pour aube de turbine ;
- la figure 2 est une vue schématique en coupe d'une barrière thermique après la réalisation d'une première étape d'un procédé selon un mode de réalisation de l'invention ;
- la figure 3 représente les quatre phases de réalisation de la seconde étape du précédé selon un mode de réalisation de l'invention ;
- la figure 4 est une vue schématique en coupe d'une barrière thermique à l'issue du procédé selon l'invention.

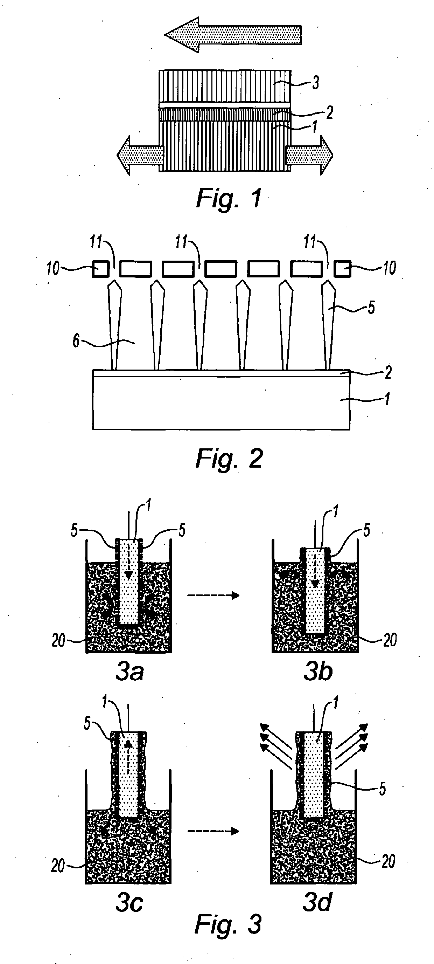

En se référant à la figure 1, on voit en coupe la composition d'une barrière thermique déposée sur la surface d'une aube de turbine, celle-ci étant baignée par un flux de gaz chaud représenté par une flèche dirigée vers la gauche de la figure. Le métal constituant l'aube, typiquement un super alliage à base nickel ou cobalt, forme un substrat 1 sur lequel est déposée une sous-couche en aluminium 2, prise en sandwich entre le substrat 1 et une couche céramique 3. La fonction de la sous-couche d'aluminium est de retenir la couche céramique et d'offrir une certaine élasticité à l'ensemble pour lui permettre d'absorber la différence de dilatation, représentée par deux flèches de sens opposé, existant entre le substrat 1 à forte dilatation et la céramique 3 à faible dilatation.

La céramique 3 représentée ici, est à structure colonnaire, ce qui autorise des déplacements latéraux, du fait de l'apparition de fissures entre les colonnes, et ce qui lui confère une bonne durée de vie. L'aluminium est alors mis en contact avec de l'oxygène véhiculé par les gaz qui circulent dans la veine de la turbomachine, ce qui se traduit par une conductivité thermique moyenne de la barrière et un endommagement progressif de celle-ci.

En se référant maintenant à la figure 2 on voit l'avancement de la réalisation d'une barrière thermique après la mise en oeuvre de la première étape du procédé selon l'invention. Au dessus du substrat 1 à recouvrir est placée une grille 10 formée de trous 11 régulièrement espacés de façon à laisser passer le dépôt en phase vapeur effectué par le procédé EB PVD ou par tout autre procédé permettant la réalisation d'un dépôt colonnaire (comme par exemple le procédé APS sous très faible pression, réalisé par la société Sulzer et connu sous le nom LPPS-TF). La grille forme un masque qui permet le dépôt de la céramique sous la forme de colonnes ou de groupement de colonnes 5 espacées les unes des autres. Leur espacement est, d'une part, suffisamment grand pour qu'un dépôt ultérieur inter colonnaire puisse être effectué et, d'autre part suffisamment rapproché pour garantir la tenue mécanique de l'ensemble de la barrière thermique. Typiquement les colonnes ou les groupements de colonnes 5 présentent une épaisseur comprise entre 10 et 300 microns et l'espacement 6 entre elles varie entre une et plusieurs dizaines de microns.

A la fin de cette première étape, la barrière thermique se trouve dans la situation représentée, avec un substrat 1 et une sous-couche 2 qui sont surmontées d'un ensemble de colonnes 5 en céramique. Ces colonnes ont traditionnellement une forme qui va en s'évasant vers le haut et qui résulte de l'agrégation progressive des particules déposées. Entre ces colonnes se trouvent des espaces vides qui seront remplis au cours de la deuxième étape du procédé selon l'invention.

La figure 3 montre, en quatre schémas référencés 3a à 3d, la réalisation de cette seconde étape. Chaque schéma correspond à une phase au cours de laquelle :
1- phase 3a : le substrat équipé de ses colonnes de céramique 5 est trempé dans une solution 20 du type sol-gel à base notamment de précurseurs de zircone yttriée, qui est utilisée dans les procédés de réalisation d'une barrière thermique isotrope. La viscosité de la solution est telle qu'elle est suffisamment fluide pour pouvoir s'insérer dans les espacements 6 entre les colonnes 5 et les remplir complètement, et elle est suffisamment visqueuse pour qu'elle reste accrochée à la pièce lors du retrait de celle-ci ;
2- phase 3b : la pièce à recouvrir reste plongée dans la solution 20 le temps que les espacements 6 entre les colonnes 5 soient correctement remplis;
3- phase 3c : la pièce est ensuite retirée de la solution 20 à une vitesse contrôlée pour qu'un film d'une épaisseur voulue puisse se constituer à la surface de la barrière thermique, de manière homogène et avec une bonne adhérence ;
4- phase 3d : elle est mise à sécher de façon que la solution 20 qui est restée emprisonnée entre les colonnes 5 se solidifie. Après séchage et élimination du solvant on obtient une couche de céramique de faible épaisseur qui reste logée entre les colonnes. L'épaisseur de céramique déposée au cours de la quatrième phase étant très faible, il est nécessaire de réaliser plusieurs fois l'opération, dite de dip-coating (ou "au trempé"), c'est-à-dire de répéter les quatre opérations après le séchage de chacune des couches formées en 3d.

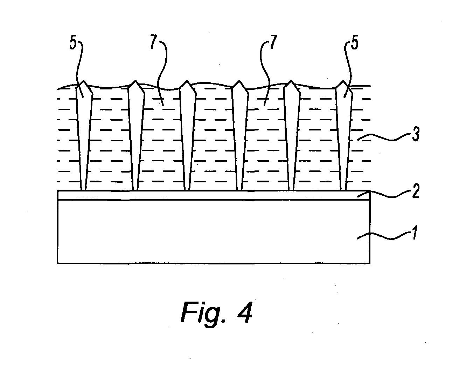

La figure 4 donne le résultat obtenu après la répétition des quatre opérations de la figure 3. Le substrat 1 et sa sous-couche 2 sont recouverts d'une barrière thermique 3 composée de colonnes 5 régulièrement espacées, entre lesquelles est déposée de la céramique sous forme isotrope 7. Cette couche isotrope présente de nombreuses bulles d'air qui sont emprisonnées, ce qui lui confère une porosité élevée, et donne ainsi à la barrière thermique une bonne résistance à la conduction de la chaleur.

On va maintenant décrire le déroulement du processus de réalisation d'une barrière thermique selon l'invention.

Le substrat constituant le matériau de l'aube à protéger est recouvert préalablement d'une sous-couche faite d'aluminium ou de tout autre métal susceptible de constituer une sous-couche de barrière thermique. Il est placé dans un appareillage pour le dépôt d'une couche en céramique, par exemple par dépôt physique en phase vapeur par faisceau d'électrons, en positionnant une grille 10, percée de trous 11, au dessus de la pièce à protéger, à une distance permettant la constitution de colonnes ou de groupement de colonnes de céramique. Le dépôt s'effectue au travers des trous 11 et la céramique se dépose sur le substrat 1 en grossissant perpendiculairement audit substrat. Du fait du masque généré par les parties pleines de la grille 10 le dépôt s'effectue selon des colonnes 5 réparties de façon discrète sur la surface du substrat 1 ; entre ces colonnes 5 subsistent des espacements 6 vides, qui seront remplis au cours de l'étape suivante du procédé. La pièce à protéger est ensuite retirée de l'appareillage de dépôt colonnaire et transférée dans un second appareillage pour le dépôt de la partie poreuse.

La seconde étape du procédé consiste en une succession d'opérations de trempés dans une solution de type sol-gel, comprenant les quatre phases décrites précédemment. Au cours de chacune de ces opérations les espacements 6 se remplissent d'une mince couche de céramique poreuse, qui s'accumule, trempé après trempé, jusqu'à former une couche 7 remplissant entièrement les espacements 6.

La réalisation de la barrière thermique se termine par un traitement thermique classique, au cours duquel la céramique se stabilise et acquière la structure cristalline souhaitée.

Au final on obtient une barrière thermique mixte comportant d'une part, une série de colonnes 5 qui assurent une bonne tenue mécanique et une bonne résistance à l'érosion par les gaz qui balayent la pièce, et, d'autre part, une couche isotrope fortement poreuse qui assure une bonne résistance à la conduction thermique en direction du substrat. Celle-ci protège le substrat 1 et la sous-couche 2 contre l'oxydation par les gaz de la veine qui circule dans le moteur. Par ailleurs la présence de colonnes permet à la barrière thermique de se déployer longitudinalement sur la surface du substrat, lors de la dilatation de celui-ci, sans risquer l'apparition de fissures qui permettraient à l'oxygène des gaz d'atteindre le métal du substrat et de l'endommager.

L'objectif de disposer d'une barrière thermique qui combine une faible conductivité thermique, une bonne tenue à l'érosion et une bonne adaptation aux contraintes thermomécaniques, est ainsi atteint.

La première étape de la réalisation de la barrière thermique a été décrite en utilisant le procédé EB PVD, mais elle peut tout aussi bien être réalisée avec les autres procédés connus de dépôt, comme la projection thermique, la présence du masque formé par la grille étant suffisante pour générer la structure colonnaire recherchée au cours de cette étape.

## Revendications

1. Procédé de dépôt d'une couche céramique sur un substrat métallique (1) pour la réalisation d'une barrière thermique, comportant une étape de dépôt de ladite céramique en structure colonnaire, ledit dépôt s'effectuant au travers d'une grille (10) percée de trous (11), positionnée parallèlement à la surface du substrat (1) de façon à réaliser au moins deux colonnes de céramique (5) séparées l'une de l'autre par un espacement (6)
**caractérisé en ce qu'**il comporte en outre une étape ultérieure de dépôt d'une couche isotrope de céramique (7) dans lesdits espacements (6).

2. Procédé selon la revendication 1 dans lequel la largeur des trous (11) est comprise entre 10 et 300 microns.

3. Procédé selon l'une des revendications 1 ou 2 dans lequel l'espacement entre les trous (11) est compris entre 10 et 100 microns.

4. Procédé selon l'une des revendications 1 à 3 dans lequel le second dépôt s'effectue par une opération de trempé du substrat (1) muni de ses colonnes (5) dans une solution du type sol-gel (20).

5. Procédé selon la revendication 4 dans lequel le dépôt isotrope s'effectue par une succession d'opérations de trempé et de retrait dans ladite solution sol-gel et d'opérations de séchage effectuées entre deux opérations de trempé et de retrait, jusqu'à obtention d'une épaisseur sensiblement égale à la hauteur des colonnes (5).

6. Procédé selon l'une des revendications 1 à 5 comportant en outre une étape finale de traitement thermique.

7. Barrière thermique déposé sur un substrat métallique **caractérisée en ce qu'**elle comporte des colonnes (5) en céramique s'étendant perpendiculairement à la surface dudit substrat et séparées les unes des autres par des espacements (6), lesdits espacements étant remplis par une couche de céramique isotrope (7).

8. Barrière thermique selon la revendication 7 dans laquelle les colonnes (5) ont une largeur maximale comprise entre 10 et 300 microns.

9. Barrière thermique selon l'une des revendications 7 ou 8 dans laquelle les espacements (6) ont une largeur comprise entre 10 et 100 microns.

10. Barrière thermique selon l'une des revendications 7 à 9 dans laquelle la couche isotrope (7) est réalisée en céramique poreuse.

11. Aube de turbine pour turbomachine comportant une barrière thermique selon l'une des revendications 7 à 10.

12. Turbomachine comportant au moins une aube selon la revendication précédente.

## Patentansprüche

1. Verfahren zum Auftragen einer keramischen Schicht auf ein Metallsubstrat (1) zum Herstellen von einer Wärmebarriere, umfassend einen Schritt des Auftragens der Keramik mit säulenförmiger Struktur, wobei das Auftragen durch ein Gitter (10) erfolgt, das mit Löchern (11) perforiert ist, das parallel zu der Oberfläche des Substrats (1) angeordnet ist, um mindestens zwei Keramiksäulen (5) zu bilden, die voneinander durch einen Zwischenraum (6) getrennt sind,
**dadurch gekennzeichnet, dass** es ferner einen weiteren Schritt des Auftragens einer isotropen Schicht aus Keramik (7) in die Zwischenräume (6) umfasst.

2. Verfahren nach Anspruch 1, wobei die Breite der Löcher (11) zwischen 10 und 300 Mikron beträgt.

3. Verfahren nach einem der Ansprüche 1 oder 2, wobei der Abstand zwischen den Löchern (11) zwischen 10 und 100 Mikron beträgt.

4. Verfahren nach einem der Ansprüche 1 bis 3, wobei das zweite Auftragen durch einen Vorgang des Eintauchens des Substrats (1), das mit seinen Säulen (5) versehen ist, in eine Sol-Gel-Lösung (20) erfolgt.

5. Verfahren nach Anspruch 4, wobei das isotrope Auftragen durch eine Folge von Vorgängen des Eintauchens in die Sol-Gel-Lösung und des Herausziehens daraus und von Vorgängen des Trocknens, die zwischen zwei Vorgängen des Härtens und des Herausziehens durchgeführt sind, bis zum Erhalten von einer Dicke, die im Wesentlichen gleich der Höhe der Säulen (5) ist, erfolgt.

6. Verfahren nach einem der Ansprüche 1 bis 5, ferner umfassend einen abschließenden Schritt der Wärmebehandlung.

7. Wärmebarriere, die auf ein Metallsubstrat aufgetragen ist, **dadurch gekennzeichnet, dass** sie Säulen (5) aus Keramik umfasst, die sich senkrecht zur Oberfläche des Substrats erstrecken und voneinander durch Zwischenräume (6) getrennt sind, wobei die Zwischenräume mit einer isotropen Schicht aus Keramik (7) aufgefüllt sind.

8. Wärmebarriere nach Anspruch 7, wobei die Säulen (5) eine maximale Breite von zwischen 10 und 300 Mikron aufweisen.

9. Wärmebarriere nach einem der Ansprüche 7 oder 8, wobei die Zwischenräume (6) eine Breite von zwischen 10 und 100 Mikron aufweisen.

10. Wärmebarriere nach einem der Ansprüche 7 bis 9, wobei die isotrope Schicht (7) aus poröser Keramik erstellt ist.

11. Turbinenschaufel für eine Turbomaschine, die eine Wärmebarriere nach einem der Ansprüche 7 bis 10 aufweist.

12. Turbomaschine, die mindestens eine Schaufel nach dem vorhergehenden Anspruch aufweist.

## Claims

1. A process for depositing a ceramic layer onto a metallic substrate (1) for producing a thermal barrier, comprising a step of depositing said ceramic in a columnar structure, said deposition taking place through a grid (10) pierced with holes (11), positioned parallel to the surface of the substrate (1) so as to produce at least two columns of ceramic (5) which are separated from one another by a spacing (6)
**characterized in that** it also comprises a subsequent step of depositing an isotropic layer of ceramic (7) in said spacings (6).

2. The process as claimed in claim 1, wherein the width of the holes (11) is between 10 and 300 microns.

3. The process as claimed in either of claims 1 or 2, wherein the spacing between the holes (11) is between 10 and 100 microns.

4. The process as claimed in one of claims 1 to 3, wherein the second deposition is carried out by an operation for dip-coating the substrate (1) equipped with its columns (5) into a solution of sol-gel type (20).

5. The process as claimed in claim 4, wherein the isotropic deposition is carried out by a sequence of dip-coating and withdrawal operations in said sol-gel solution and drying operations carried out between two dip-coating and withdrawal operations, until a thickness substantially equal to the height of the columns (5) is obtained.

6. The process as claimed in one of claims 1 to 5, additionally comprising a final step of heat treatment.

7. A thermal barrier deposited on a metallic substrate, **characterized in that** it comprises ceramic columns (5) that extend perpendicular to the surface of said substrate and that are separated from one another by spacings (6), said spacings being filled with an isotropic ceramic layer (7).

8. The thermal barrier as claimed in claim 7, wherein the columns (5) have a maximum width of between 10 and 300 microns.

9. The thermal barrier as claimed in either of claims 7 or 8, wherein the spacings (6) have a width of between 10 and 100 microns.

10. The thermal barrier as claimed in one of claims 7 to 9, wherein the isotropic layer (7) is made of porous ceramic.

11. A turbine blade for a turbomachine comprising a thermal barrier as claimed in one of claims 7 to 10.

12. A turbomachine comprising at least one blade as claimed in the preceding claim.
